# EUROPEAN PATENT APPLICATION

(11) **EP 1 589 549 A1**
(43) Date of publication of application: **26.10.2005**
(21) Application number: 04009743.8
(22) Date of filing: 23.04.2004
(51) Int. Cl.: H01G 9/20, H01L 31/18, H01L 51/40

(54) **A method of producing a porous semiconductor film on a substrate**

(71) Applicant: Sony Deutschland GmbH, 50829 Köln (DE)
(72) Inventor: Dürr, Michael, 70327 Stuttgart (DE); Nelles, Gabriele, 70327 Stuttgart (DE); Yasuda, Akio, 70327 Stuttgart (DE)
(74) Representative: Appelt, Christian W.

(57) **Abstract**

The invention relates to a method of producing a porous semiconductor film and to a suspension of semiconductor particles. It further relates to a porous semiconductor film produced by the method, and to an electronic device, in particular a solar cell comprising said semiconductor film.

## Description

The invention relates to a method of producing a porous semiconductor film and to a suspension of semiconductor particles. It further relates to a porous semiconductor film produced by the method, and to an electronic device, in particular a solar cell comprising said semiconductor film.

Single crystal solar cells show energy conversion efficiencies as high as ~ 25%. Where the Si-based crystals are no longer single crystals but polycrystalline, the highest efficiencies are in the range of ~ 18%, and with amorphous Si, the efficiencies are ~ 12%. Solar cells based on Si are, however, rather expensive to manufacture, even in the amorphous Si version. Therefore alternatives have been developed based on organic compounds and/or a mixture of organic and inorganic compounds, the latter type solar cells often being referred to as hybrid solar cells. Organic and hybrid solar cells have proved to be cheaper to manufacture, but seem to have yet comparably low efficiencies even when compared to amorphous Si cells. Due to their potential inherent advantages such as light weight, low-cost fabrication of large areas, environmentally friendly materials, or preparation on flexible substrates, efficient organic devices might prove to be technically and commercially useful "plastic solar cells". Recent progress in solar cells based on dye-sensitised nanocrystalline titanium dioxide (porous TiO₂) semiconductor and a liquid redox electrolyte demonstrates the possibility of a high energy conversion efficiencies in organic materials. (B.O-Regan and M. Grätzel, Nature 353 (1991, 737).
Photoelectrochemical cells based on sensitisation of nanocrystalline TiO₂ by molecular dyes (dye sensitised solar cells, DSSC) have attracted great attention since their first announcement as efficient photovoltaic devices (B. O'Regan and M. Grätzel, (see above); US5084365). One part of the ongoing investigations is to exploit the cells' potential applicability on flexible substrates and with this the potential of fabricating flexible solar cells. The main challenge to be solved prior to the successful introduction of such flexible DSSCs is the stability of the TiO₂ layers applied on flexible substrates. No innovative techniques have been reported so far and only standard techniques as screen printing, doctor blading, drop casting, etc. are commonly applied.

In addition to the flexibility, the restricted range of temperature applicable to plastic substrates limits so far the efficiency of flexible DSSC. With respect to this, the most successful way to fabricate flexible DSSCs has been so far to screen print or doctor blade the TiO₂ layer with the subsequent application of high pressures for low temperature sintering (see Lindström et al. Nano Lett. 2001, 1, 97; WO 00/72373). This process additionally allows for a post-application patterning of the substrate.

The disadvantages of the state of the art of applying the TiO₂ film on the substrates by standard techniques as described in Lindström et al. (see above) and WO 00/72373 can be summarized as follows:
(i) the porous films are in general very brittle and do not withstand bending of the (flexible) substrate. The films prepared according to the prior art have poor adhesive properties and easily come off the substrate.
(ii) the standard techniques lack the possibility to directly apply the nanoporous TiO₂ in a textured manner. In WO 00/72373 a method of post-application patterning is described but starts with a fully covered substrate. This method therefore is more costly than a direct patterning with respect to the amount of material consumed.
(iii) most of the standard techniques known from the prior art cannot be applied to non-flat substrates.
(iv) most of the standard techniques use mixtures of TiO₂ and organic binders for better handling of the TiO₂. Those additional binders are not suited for low temperature applications, since they have to be burned at temperatures above 300°C. TiO₂ solutions without binders are found to be difficult to be applied since a certain viscosity is necessary for most of the techniques. Binder-free techniques are described in WO 00/72373 which usually lead to low quality films. The method described in WO 00/72373 includes a pressing procedure and is not applicable in general.

Accordingly it was an object of the present invention to provide for a method of production of dye sensitised solar cells which can be performed on flexible substrates and which leads to semiconductor films having a high longevity. Furthermore it was an object of the present invention to provide for a method of production which is cheap and can be applied to large substrates. Moreover, it was an object of the present invention to provide for a method of production which can be applied on irregular substrates and substrates of almost any shape.

All these objects are solved by a method of producing a porous semiconductor film on a substrate comprising the steps:
a) preparing a suspension of semiconductor particles in at least one liquid, in which said semiconductor particles are not soluble,
b) applying said suspension on a substrate by ink-jet-printing, thereby forming a printed porous semiconductor film.

In one embodiment, the method according to the present invention comprises the additional step:
c) drying and/or sintering the printed porous semiconductor film, thereby forming a dried and/or sintered porous semiconductor film.

Preferably said suspension of semiconductor particles is applied in several stages, each stage comprising the application of one layer only, wherein, preferably said one layer of semiconductor particles comprises about 1 to 10, preferably 2 to 8, more preferably 3 to 5 monolayers of semiconductor particles, wherein, more preferably, after each stage of applying said suspension of semiconductor particles, a drying and/or sintering step according to the present invention, as described above, ensues.

In one embodiment, said steps b) and c) are performed 1 - 1000 times, preferably 1 - 100 times, more preferably 1 - 75 times, and most preferably 20 - 75 times. In another embodiment, they are performed 1 to 50 times.

In one embodiment, said porous semiconductor film has a thickness in the range of from about 1 to about 100 µm.

In one embodiment, said suspension of semiconductor particles is applied in spots of defined size(s), such that the resulting printed and/or dried and/or sintered semiconductor film is a textured film, wherein, preferably, said spots of defined size(s), when taken together, cover more than 20%, preferably more than 50%, more preferably 70% or more, of the surface area of said substrate.

In one embodiment, said ink-jet printing is performed at a temperature in the range of from 1 to 200°C, preferably 20 - 180°C, more preferably 50°C - 150°C.
In one embodiment, said drying and/or sintering step c) is performed at a temperature/temperatures in the range of about 15 to 250°C, preferably 50 - 150°C, and wherein, preferably, said drying and/or sintering step is performed at said temperature(s) for a time in the range from 1 min to 60 min, preferably 15 to 45 min.

In one embodiment, several suspensions of semiconductor particles of different types are prepared, and wherein said porous semiconductor film is produced as a multilayer arrangement using a different suspension of semiconductor particles for all, some or one layer within the multilayer arrangement.

In one embodiment, said semiconductor particles, after having been printed onto said substrate, do not undergo a development step, in particular not a hydrolysis step or a condensation step.

Preferably step a) and/or b) occurs in the absence of a amphiphilic material, in particular in the absence of a surfactant, and/or it occurs in the absence of a binder material, e.g. a polymeric binder material.

In one embodiment, said suspension of semiconductor particle is prepared in step a) by adding said semiconductor particles to said liquid or vice versa.

Preferably said semiconductor particles have a size in the range of from about 5 nm to about 500 nm in diameter.

The objects of the present invention are also solved by a suspension of semiconductor particles particularly for use in the method according to the present invention, comprising semiconductor particles and at least one liquid, in which said semiconductor particles are not soluble, characterized in that said semiconductor particles have a size in the range of from about 5 nm to about 500 nm.

In one embodiment said semiconductor particles are aggregates.

In one embodiment, the suspension has an electrical conductivity which is adjusted for use by the presence of an acid, a base and/or a diluent liquid, e.g. an alcohol.

Preferably the electrical conductivity of said suspension after adjustment is in the range of from about 600 to about 2000 µSiemens/cm.

Preferably said acid is HNO₃ and said alcohol is a C₁-C₄ alcohol, preferably ethanol, propanol or isopropanol or a mixture thereof.

In one embodiment, said at least one liquid, in which said semiconductor particles are not soluble, is a mixture of water and alcohol, preferably isopropanol, wherein, preferably, the ratio of water:alcohol is in the range of from 0,5 to 2, preferably about 1.

In one embodiment, said semiconductor particles are oxide particles, preferably TiO₂-particles.

In one embodiment said suspension contains ≤ 10 wt.%, preferably 2 - 5 wt.% and more preferably about 3 wt.% of semiconductor particles. It is clear to someone skilled in the art that a wide variety of semiconductor particles can be used for practicing the present invention. Examples of these are, without being limited thereto: TiO₂, SnO₂, ZnO, Nb₂O₅, ZrO₂, CeO₂, WO₃, SiO₂, Al₂O₃, CuAlO₂, SrTiO₃ and SrCu₂O₂, or a complex oxide containing several of these oxides.

The objects of the present invention are also solved by a porous semiconductor film, produced by the method according to the present invention, preferably by use of a suspension of semiconductor particles as defined above.

In one embodiment, it has an average pore size in the range of from about 5 nm - 50 nm and/or it has an average porosity of 30% - 80%, preferably 40% - 60%, and more preferably around 50%. In this context, and as used herein, a film having x% porosity means that x% of the total volume occupied by the film are void space.

In one embodiment said film is on a substrate, wherein, preferably, the substrate is flexible, and wherein, more preferably, the substrate has a flat surface or an irregular surface.

It is also clear to someone skilled in the art that there exist a wide variety of flexible substrates. For example, flexible, mainly polymeric (with the exception of steel) substrates may be used, such as but not limited thereto: polyethylene terephthalate (PET), polyethylene naphthalate (PEN), polyethersulfone (PES), polyimide (Kapton), polyetheretherketone (PEEK), polyetherimide (PEI), stainless steel, OHP (overhead transparencies)

In one embodiment, the film comprises a plurality of spots of semiconductor particles, said spots being spaced apart, preferably ≤ 100 µm spaced apart.

The objects of the present invention are also solved by an electronic device, produced using the method according to the present invention and/or comprising a porous semiconductor film according to the present invention.

Preferably the electronic device is a solar cell.

Preferably, the electronic device, in particular the solar cell according to the present invention, has a stability as reflected by its capability of surviving more than a thousand bending cycles without losing more than 15% of its original power conversion efficiency.

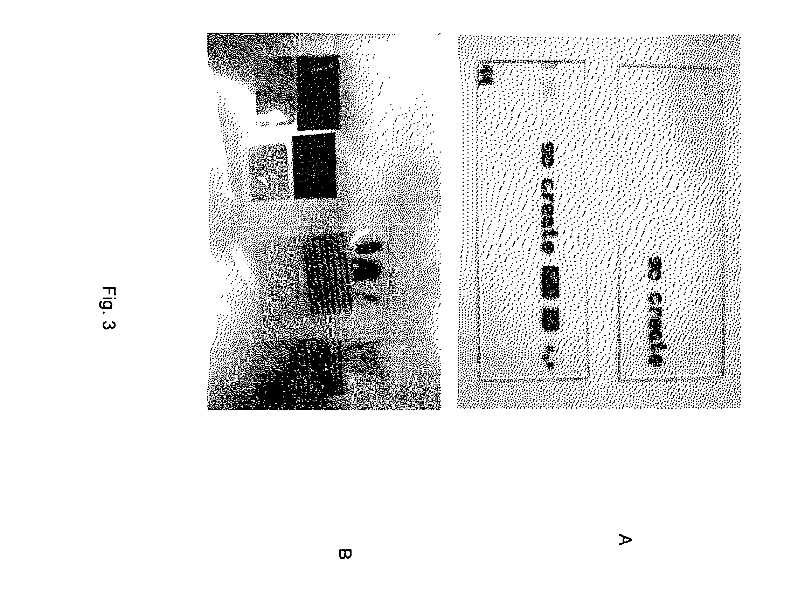

The above mentioned disadvantages in fabricating DSSCs, especially flexible DSSCs, can be overcome by the application of the semiconductor particles, in particular the TiO₂ particles, by means of ink-jet printing techniques. In one realisation of ink-jet techniques, i.e. continuous ink-jet printing, electrical conductive ink of any kind is used. Electrical conductivity is necessary because small droplets of the ink produced by a small nozzle are charged in an area of high electric field. Charging the droplets allows for their deflection in a second pair of electrodes and therefore for the precise locating of where the ink enters the substrate (compare Fig. 1). The technique is well established in many manufacturing processes, e.g. labelling of cables. Other realisations with nonconductive ink are also known (drop on demand). The present inventors developed a semiconductor ink, in particular a TiO₂ ink, suitable for the application of ink-jet printing with regard to conductivity, semiconductor content, particle size and -aggregation, and solvent. This ink allows for being printed in several cycles on the substrates, the number of cycles depending on layer thickness intended to be printed. The substrate may be flat or shaped in any other kind (compare Fig. 2). Moreover, any kind of pattern of TiO₂ layers, e.g. with small, separated spots of TiO₂ can be printed (Fig. 3). These patterns can be freely chosen and no restriction by the hardware is given. Printing the porous layers by means of ink-jet printing enhances the stability of the films in two ways: firstly, the printed films as such are less brittle and more stable since the layers are dried cycle by cycle and no internal stress is built up during the application and drying of the layer. Secondly, if the size of the semiconductor spots of the patterns is chosen well, the stress applied by bending the material is much less than for a large continuous porous layer. Additionally to the increased stability of the layers, the required low temperature sintering, when applied to flexible substrates, of the porous films is facilitated by the layer-by-layer application using ink-jet techniques. With every printing layer, only about 1 to 10, preferably 2 to 8, more preferably 3 to 5 monolayers of the semiconductor particles are applied at once (one monolayer having approximately the thickness of a semiconductor particle). This allows for a much better arrangement of the semiconductor particles with respect to each other, and therefore for better connections between the single particles. By the layer-by-layer application of the semiconductor particles on the substrate, no organic or other binders are necessary together with the semiconductor since ink of a viscosity can be used which viscosity is lower than that used in other methods, such as doctor blading or screen printing. A typical viscosity value for doctor blading is for example 0.1 - 0.2 Pa·s at a shear rate of 2000s⁻¹. The viscosity of the suspension according to the present invention is preferred to be lower than this value. Therefore no high temperatures are required for the removal of the binder material. Application of low viscosity ink by standard methods usually leads to films of poorer quality. To further improve the efficiency of the ink-jet printed DSSC according to the present invention, combination with other low temperature sintering processes and/or compression processes, as exemplified in Lindström et al. (see above) or WO 00/72373 can be applied.

Reference is now made to the figures, wherein
**Figure 1** show the principle working scheme of ink-jet-printing in the method according to the present invention. A nozzle is used for generating drops of the suspension of semiconductor particles, which drops are becoming charged by means of electrodes and then are directed to their envisaged position on the substrate by means of deflection electrodes placed behind the charging electrodes.
**Figure 2** shows the possibility of printing on round shaped substrates using the ink-jet methodology of the present invention. A rotatable printer head can be used for directing the jet of ink at the appropriate angle to the substrate
**Figure 3** shows examples of structured (panel A) and non-structured prints (panel B).
**Figure 4** shows the schematics of a flexible dye sensitised solar cell with a structured semiconductor film, e.g. TiO₂ film. The flexible substrate may for example be PET Other possible flexible, preferably polymeric, substrates may be, without being limited thereto: polyethylene terephthalate (PET), polyethylene naphthalate (PEN), polyethersulfone (PES), polyimide (Kapton), polyetheretherketone (PEEK), polyetherimide (PEI), stainless steel, OHP (overhead transparencies). The semiconductor layer, preferably the TiO₂ layer is treated with an alcoholic solution of an appropriate dye (for example cis-bis(isothiocyanato)bis(2,2'-bipyridyl-4,4'-dicarboxylic acid) ruthenium (II), red dye) and thereafter filled with a polymer electrolyte (for example PEO (polyethylene oxide) in PC-EC (propylene carbonate-ethylene carbonate), with e.g. iodine/iodide (0,015 M) serving as redox-couple. Additionally spacer balls of an insulating material prevent direct contact between the TiO₂ layer and counter electrode, e.g. made of platinum.
**Figure 5** shows the I-V-chracteristics of a fully flexible solar cell produced according to the method of the present invention.
**Figure 6** shows the relative efficiency of the solar cell of figure 5 as a function of bending cycles. The bending cycles were performed manually by producing a curvature of the substrate as small as r = 0.5 cm, with r denoting the radius of a theoretical circle, of which the bent substrate would form part of the circumference. Typical substrates had a length of about 1 - 2 cm.
**Figure 7** shows the dependency of the efficiency of a solar cell produced according to the method of the invention on the number of ink-jet-printing cycles used for printing the semiconductor layer. The optimum efficiency was achieved with about 20 - 75 cycles, preferably about 50 cycles, corresponding to a an average thickness of approximately 5 µm of the semiconductor layer.

The invention will now be further described by reference to the following example which is given to illustrate, not to limit the present invention.

### Example

An example of a flexible DSSC with patterned TiO₂ layer is shown in Fig. 4. The flexible substrates are for example made of PEN with a transparent conductive oxide (TCO), e.g. conductive ITO (indium tin oxide) layer (approx. 100 nm). The porous TiO₂ layer is applied on the PEN substrate by means of continuous ink-jet printing with a thickness of about 5 µm. A typical example of a suspension according to the present invention is: 3 wt.% TiO₂ (with particles having a diameter of ~ 18 nm) in H₂O: isopropanol (1:1), conductivity 1200 µSiemens/cm adjusted by HNO₃. The suspension is used in 50 printing cycles. The structure covers about 30 - 40% of the surface and consists of dots of about 1 mm². It has been sintered at 200°C for 30 min. After application and drying/sintering of the TiO₂, red dye molecules are attached as a monolayer to the TiO₂ via self-assembling out of a solution in ethanol (0,3 mM). The coloured porous layer is filled with a polymer electrolyte (PEO in PC/EC) with iodine/iodide (0,015 M) serving as redox-couple. A 5 µm thick bulk layer of the same polymer electrolyte bridges the gap between porous layer and a flat, smooth platinum film (50 nm) applied again on a PEN substrate. To avoid direct contact between the TiO₂ layer and the platinum counter electrode, spacer balls made of glass with a diameter of 5 µm are introduced between the two electrodes.

The current-voltage-characteristics of such a solar cell is shown in Fig. 5. These cells show a very good flexibility with minor losses after more than a thousand bending cycles (Fig. 6), and a decent power conversion efficiency of 2.3%. With an optimised structure, efficiencies higher 5% should be reachable.

By using the method of the present invention, it is possible to apply semiconductor particles in a defined manner on substrates of almost every possible shape. It is furthermore possible to directly apply structured and/or patterned porous layers of semiconductor, which makes the method much less cost intensive due to substantial savings in semiconductor material in the first place. Furthermore the semiconductor films produced by the method according to the present invention show an extremely high longevity. They also show a good efficiency when used in photovoltaic devices, even though they have only been sintered at low temperatures.

The features of the present invention disclosed in the specification, the claims and/or in the accompanying drawings, may, both separately, and in any combination thereof, be material for realising the invention in various forms thereof.

## Claims

1. A method of producing a porous semiconductor film on a substrate comprising the steps:
a) preparing a suspension of semiconductor particles in at least one liquid, in which said semiconductor particles are not soluble,
b) applying said suspension on a substrate by ink-jet-printing, thereby forming a printed porous semiconductor film.

2. The method according to claim 1, comprising the additional step:
c) drying and/or sintering the printed porous semiconductor film, thereby forming a dried and/or sintered porous semiconductor film.

3. The method according to any of the foregoing claims, wherein said suspension of semiconductor particles is applied in several stages, each stage comprising the application of one layer only.

4. The method according to claim 3, wherein said one layer of semiconductor particles comprises about 1 to 10, preferably 2 to 8, more preferably 3 to 5 monolayers of semiconductor particles.

5. The method according to any of claims 3 - 4, wherein after each stage of applying said suspension of semiconductor particles, a drying and/or sintering step according to claim 2 ensues.

6. The method according to any of claims 2 - 5, wherein said steps b) and c) are performed 1 - 1000 times, preferably 1 - 100 times, more preferably 20 - 75 times.

7. The method according to any of the foregoing claims, wherein said porous semiconductor film has a thickness in the range of from about 1 to about 100 µm.

8. Method according to any of the foregoing claims, wherein said suspension of semiconductor particles is applied in spots of defined size(s), such that the resulting printed and/or dried and/or sintered porous semiconductor film is a textured film.

9. The method according to claims 8, wherein said spots of defined size(s), when taken together, cover more than 20%, preferably more than 50%, more preferably 70% or more, of the surface area of said substrate.

10. The method according to any of the foregoing claims, wherein said ink-jet printing is performed at a temperature in the range of from 1 to 200°C, preferably 20 - 180°C, more preferably 50°C - 150°C.

11. The method according to any of claims 2 - 10, wherein said drying and/or sintering step c) is performed at a temperature/temperatures in the range of about 15 to 250°C, preferably 50°C - 150°C.

12. The method according to claim 11, wherein said drying and/or sintering step is performed at said temperature(s) for a time in the range from 1 min to 60 min, preferably 15 min to 45 min.

13. The method according to any of the foregoing claims, wherein several suspensions of semiconductor particles of different types are prepared, and wherein said porous semiconductor film is produced as a multilayer arrangement using a different suspension of semiconductor particles for all, some or one layer within the multilayer arrangement.

14. The method according to any of the foregoing claims, wherein said semiconductor particles, after having been printed onto said substrate, do not undergo a development step, in particular not a hydrolysis step or a condensation step.

15. The method according to any of the foregoing claims, wherein step a) and/or b) occurs in the absence of an amphiphilic material, in particular in the absence of a surfactant, and/or it occurs in the absence of a binder material, e.g. a polymeric binder material.

16. The method according to any of the foregoing claims, wherein said suspension of semiconductor particles is prepared in step a) by adding said semiconductor particles to said liquid or vice versa.

17. The method according to any of the foregoing claims, wherein said semiconductor particles have a size in the range of from about 5 nm to about 500 nm in diameter.

18. A suspension of semiconductor particles particularly for use in the method according to any of claims 1 - 17, comprising semiconductor particles and at least one liquid, in which said semiconductor particles are not soluble, **characterized in that** said semiconductor particles have a size in the range of from about 5 nm to about 500 nm.

19. The suspension according to claim 18, **characterized in that** said semiconductor particles are aggregates.

20. The suspension according to any of claims 18 - 19, **characterized in that** it has an electrical conductivity which is adjusted for use by the presence of an acid, a base and/or a diluent liquid, e.g. an alcohol.

21. The suspension according to claim 20, wherein the electrical conductivity of said suspension after adjustment is in the range of from about 600 to about 2000 µSiemens/cm.

22. The suspension according to claim 21, wherein said acid is HNO₃ and said alcohol is a C₁-C₄ alcohol, preferably ethanol, propanol or isopropanol or a mixture thereof.

23. The suspension according to any of claims 18 - 22, wherein said at least one liquid, in which said semiconductor particles are not soluble, is a mixture of water and alcohol, preferably isopropanol.

24. The suspension according to claim 23, wherein the ratio of water:alcohol is in the range of from 0,5 to 2, preferably about 1.

25. The suspension according to any of claims 18 - 24, wherein said semiconductor particles are oxide particles, preferably TiO₂-particles.

26. The suspension according to any of the foregoing claims, wherein said semiconductor particles are present at an amount of ≤ 10 wt.%, preferably 2 - 5 wt.%, and more preferably about 3 wt.%.

27. A porous semiconductor film, produced by the method according to any of claims 1 - 17, preferably by use of a suspension of semiconductor particles as defined in any of claims 18 - 26.

28. The porous semiconductor film according to claim 27, having an average pore size in the range of from about 5 nm - 50 nm , and/or having an average porosity of 30% - 80%, preferably 40% - 60%, and more preferably around 50%.

29. The porous semiconductor film according to any of claims 27 - 28, on a substrate.

30. The porous semiconductor film according to claim 29, wherein the substrate is flexible.

31. The porous semiconductor film according to any of claims 29 - 30, wherein the substrate has a flat surface or an irregular surface.

32. The porous semiconductor film according to any of claims 27 - 31, comprising a plurality of spots of semiconductor particles, said spots being spaced apart, preferably ≤ 100 µm spaced apart.

33. An electronic device, produced using the method according to any of claims 1 - 17, and/or comprising a porous semiconductor film according to any of claims 27 - 32.

34. The electronic device according to claim 33, which is a solar cell.

35. The electronic device according to claim 33, in particular the solar cell according to claim 34, having a stability as reflected by its capability of surviving more than a thousand bending cycles without losing more than 15% of its original power conversion efficiency.
